(19) Europäisches Patentamt
European Patent Office
Office européen des brevets

(11) EP 2 585 838 B1

(12) FASCICULE DE BREVET EUROPEEN

(45) Date de publication et mention
de la délivrance du brevet:
**08.04.2015 Bulletin 2015/15**

(51) Int Cl.:
***G06F 17/00*** (2006.01)   ***G01R 31/08*** (2006.01)
***G01R 31/12*** (2006.01)

(21) Numéro de dépôt: **11726840.9**

(22) Date de dépôt: **23.06.2011**

(86) Numéro de dépôt international:
**PCT/EP2011/060537**

(87) Numéro de publication internationale:
**WO 2011/161210 (29.12.2011 Gazette 2011/52)**

(54) **PROCEDE DE LOCALISATION D'ARC INTERNE DANS UNE LIGNE A ISOLATION GAZEUSE ET DISPOSITIF ASSOCIE**

VERFAHREN ZUR ORTUNG EINES INNEREN LICHTBOGENS IN EINER GASISOLIERTEN LEITUNG UND ZUGEHÖRIGE VORRICHTUNG

METHOD OF LOCATING AN INTERNAL ARC IN A GAS INSULATED LINE AND ASSOCIATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.06.2010 FR 1054991**

(43) Date de publication de la demande:
**01.05.2013 Bulletin 2013/18**

(73) Titulaire: **Alstom Technology Ltd.**
**5400 Baden (CH)**

(72) Inventeurs:
• **JUGE, Patrice**
**F-74150 Marcellaz Albanais (FR)**
• **GRANELLI, Guillaume**
**F-73700 Seez (FR)**

(74) Mandataire: **Ilgart, Jean-Christophe et al**
**Brevalex**
**95, rue d'Amsterdam**
**75378 Paris Cedex 8 (FR)**

(56) Documents cités:
**FR-A1- 2 719 125    JP-A- 57 035 768**

• **SETSUO FUKUDA: "Current-Carrying and Short-Circuit Tests on EHV Cables Insulated with SF6 Gas", IEEE TRANSACTIONS ON POWER APPARATUS AND SYSTEMS, IEEE INC. NEW YORK, US, vol. 82, no. 2, 1 février 1969 (1969-02-01), pages 147-156, XP011159998, ISSN: 0018-9510**

**Description**

<u>Domaine technique et art antérieur</u>

L'invention concerne un procédé de localisation d'arc interne dans une ligne à isolation gazeuse ainsi qu'un dispositif apte à mettre en oeuvre le procédé.

L'invention s'applique à la localisation de défauts sur les lignes à isolation gazeuse dans le but de faciliter la maintenance de celles-ci.

Une ligne à isolation gazeuse est constituée d'un conducteur placé à l'intérieur d'une enveloppe conductrice remplie d'un gaz diélectrique sous pression. L'énergie électrique est transportée par le conducteur alors que l'enveloppe conductrice est portée à un potentiel de référence (potentiel zéro). La nature et la pression du gaz diélectrique sont choisies en fonction de la tension qui existe entre le conducteur et l'enveloppe conductrice afin de garantir l'isolation électrique. A titre d'exemple, une enveloppe d'environ 1m de diamètre et remplie d'un mélange d'hexafluorure de soufre ($SF_6$) dans de l'azote ($N2$) sous pression permet d'isoler un conducteur en aluminium transportant une puissance de l'ordre de 1000 à 2000 mégawatts sous une tension de l'ordre de 245000 à 400000 Volts.

Le potentiel nul de l'enveloppe conductrice et le faible encombrement de celle-ci font qu'une ligne à isolation gazeuse est utilisée au ras du sol, voire enterrée.

Une ligne à isolation gazeuse peut avoir une longueur de plusieurs kilomètres. Afin de garantir une bonne pressurisation du gaz, la ligne est compartimentée, c'est-à-dire formée d'une succession de compartiments, le gaz contenu dans un compartiment étant isolé du gaz contenu dans les compartiments voisins.

Plusieurs systèmes de localisation d'arc interne de ligne à isolation gazeuse sont connus de l'art antérieur.

Il existe, par exemple, des systèmes basés sur la détection de la lumière. Ces systèmes sont réservés aux lignes ayant des compartiments de faibles volumes. Les capteurs de lumière nécessitent d'être montés à espace régulier, par exemple tous les 20m, en prenant en compte l'atténuation de la lumière et la géométrie de la ligne. Ceci représente un inconvénient. Un autre inconvénient réside en ce que l'apparition d'un arc s'accompagne fréquemment de la formation de poussières dont la présence peut faire partiellement ou totalement écran à la lumière.

Le document FR 2 719 125 A1 (GEC ALSTHOM T & D SA, 27 .10.1995) divulgue un dispositif pour la localisation d'un tronçon en défaut dans un câble électrique à isolation gazeuse par une fibre optique pour recueillir et transmettre de la lumière générée par un arc électrique.

L'invention ne présente pas les inconvénients mentionnés ci-dessus.

<u>Exposé de l'invention</u>

En effet, l'invention concerne un procédé de localisation d'un arc interne qui survient dans une ligne à isolation gazeuse constituée d'une succession de compartiments $CP_i$ (i=1, 2, ..., N) remplis de gaz, caractérisé en ce que, chaque compartiment $CP_i$ étant entouré par un tore de courant $TC_i$ (i=1, 2, ..., N) parcouru par un courant $I_i$ sensiblement identique d'un compartiment à l'autre et étant muni d'au moins un capteur de pression $P_i$ apte à mesurer la pression du gaz à l'intérieur du compartiment, le procédé comprend :

- une lecture, à une fréquence d'échantillonnage, des différents courants $I_i$ qui parcourent les différents tores de courant,
- un calcul, à la fréquence d'échantillonnage, des différences de courants $I_{diff/i}$ telles que :

$$I_{diff/i} = I_{i+1} - I_i,$$

avec une mise en mémoire des différences de courant calculées,
- une comparaison des différences de courant $I_{diff/i}$ mises en mémoire avec une valeur de seuil de courant et, à un instant $t_t$, dès lors qu'une différence de courant est supérieure ou égale à la valeur de seuil :
- un déclenchement d'une succession de mesures de pression par le capteur de pression $P_i$, avec une mise en mémoire des valeurs de pression mesurées,
- une étape de calcul, à partir des variations temporelles des mesures de pression mises en mémoire, d'un instant $t_m$ de montée de pression, comme instant auquel commence à croître la pression mesurée par le capteur de pression $P_i$,
- une étape de calcul d'une durée $\Delta tp$ comme la différence des instants $t_m$ et $t_t$,
- un calcul d'un instant $t_0$ qui caractérise l'apparition d'un arc interne dans le compartiment $CP_i$ à partir des variations temporelles de différences de courant mises en mémoire,

- un calcul d'une durée $\Delta t_i$ comme différence des instants $t_t$ et $t_0$,
- un calcul d'une durée $\Delta t$ comme la somme des durées précédemment calculées $\Delta t_i$ et $\Delta t_P$, et
- un calcul de la distance d qui sépare le capteur de pression $P_i$ de l'endroit où est apparu le défaut par l'équation :

$$d=V/\Delta t$$

où V est la vitesse de propagation du son dans le gaz.

L'invention concerne également un dispositif de localisation d'un arc interne qui survient dans une ligne à isolation gazeuse constituée d'une succession de compartiments $CP_i$ (i=1, 2, ..., N) remplis de gaz, caractérisé en ce qu'il comprend :

- N tores de courant $TC_i$ (i=1, 2, ..., N), chaque tore de courant entourant un compartiment et étant parcouru par un courant $I_i$ sensiblement identique d'un compartiment à l'autre,
- N modules de détection $DC_i$ (i=1, 2, ..., N), chaque module de détection étant apte à lire le courant $I_i$ qui parcourt le tore de courant $TC_i$ et le courant $I_{i-1}$ qui parcourt le tore de courant $TC_{i-1}$ et comprenant des moyens aptes à calculer les différences des courants $I_i$ et $I_{i-1}$, à mémoriser les différences de courant calculées et à délivrer, à un instant $t_t$, un signal de commande dès lors que la différence des courants $I_i$ et $I_{i-1}$ est supérieure ou égale à un seuil de courant,
- au moins un capteur de pression $P_i$ monté sur chaque compartiment $CP_i$ et apte à mesurer la pression du gaz à l'intérieur du compartiment,
- N modules de surveillance de gaz $MG_i$ (i=1, 2, ..., N), chaque module de surveillance comprenant des moyens aptes à déclencher, sous l'action du signal de commande, via le capteur de pression $P_i$, des mesures successives de pression du gaz contenu dans le compartiment $P_i$ et à mémoriser les mesures de pression successives effectuées, et
- des moyens aptes à calculer :

→ un instant $t_m$ de montée de pression, comme instant auquel commence à croître la pression mesurée par le capteur de pression $P_i$, à partir des variations temporelles des mesures de pression mises en mémoire,
→ une durée $\Delta t_P$ comme la différence des instants $t_m$ et $t_t$,
→ un instant $t_0$ qui caractérise l'apparition d'un arc interne dans le compartiment $CP_i$ à partir des variations temporelles de différences de courant mises en mémoire,
→ une durée $\Delta t_i$ comme différence des instants $t_t$ et $t_0$,
→ une durée $\Delta t$ comme la somme des durées précédemment calculées $\Delta t_i$ et $\Delta t_p$, et
→ une distance d qui sépare le capteur de pression $P_i$ de l'endroit où est apparu le défaut par l'équation :

$$d=V/\Delta t$$

où V est la vitesse de propagation du son dans le gaz.

Le procédé de l'invention présente un avantage particulièrement intéressant qui est de ne pas déclencher de mesure de pression sous l'effet de bruit. En effet, la durée $\Delta t_i$ qui sépare les instants $t_t$ et $t_0$ peut être relativement longue (par exemple égale à 100ms) de sorte que la valeur du seuil de courant qui est destinée à traduire l'apparition de l'arc peut également être relativement importante et, en tous les cas, supérieure aux valeurs de fluctuations du bruit.

Egalement, le procédé de l'invention présente l'avantage de rester opérationnel pour des temps de détection courts (de l'ordre de quelques ms), le temps de détection étant un paramètre de réglage. Un telle réactivité est nécessaire pour détecter un défaut d'isolation lors des essais diélectriques, hors charge, d'un matériel Haute Tension, défaut qui se traduit par l'apparition d'un pic de courant.

L'invention est avantageusement adaptée à une large gamme de géométries et de tensions, par exemple des enveloppes d'environ 0.4m à 1m de diamètre sous une tension de l'ordre de 245000 à 400000 Volts, ou encore des enveloppes de plus petit diamètre sous des tensions plus basses, par exemple 170000 Volts.

Brève description des figures

D'autres caractéristiques et avantages de l'invention apparaîtront à la lumière de la description qui va suivre faite en référence aux figures jointes, parmi lesquelles :

- La figure 1 représente un schéma de principe de dispositif de localisation d'arc interne de ligne à isolation gazeuse de l'invention ;
- La figure 2 représente un schéma de principe du procédé de localisation d'arc interne de ligne à isolation gazeuse de l'invention mis en oeuvre par le dispositif de la figure 1;
- Les figures 3A-3C représentent des signaux de réponse, mesurés ou calculés, qui sont utiles à une bonne compréhension de l'invention ;
- Les figures 4-6 représentent des vues détaillées d'un tore de courant qui participe au dispositif de localisation d'arc interne de ligne à isolation gazeuse selon le mode de réalisation préférentiel de l'invention ;
- Les figures 7 et 8 représentent deux vues détaillées d'un montage, sur une ligne à isolation gazeuse, du tore de courant représenté aux figures 4-6.

Sur toutes les figures, les mêmes références désignent les mêmes éléments.

Exposé détaillé d'un mode de réalisation particulier de l'invention

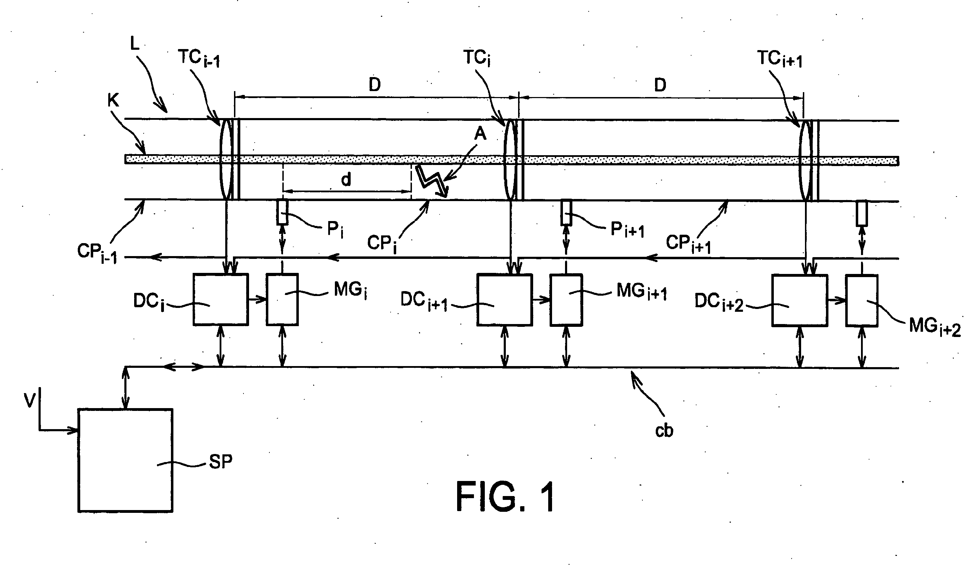

La figure 1 représente un schéma de principe d'un exemple de dispositif de localisation d'arc interne de ligne à isolation gueuze de l'invention.

Une ligne à isolation gazeuse L comprend plusieurs compartiments $CP_i$ (i=1, 2, ..., 3, etc.) traversés par un conducteur central K. Chaque compartiment $CP_i$, de longueur D, contient du gaz sous pression, par exemple du SF6 sous une pression de 5 bars à la température de 20°C. Comme cela a été mentionné précédemment, le gaz contenu dans un compartiment est isolé du gaz contenu dans les autres compartiments.

Le dispositif de localisation d'arc interne de l'invention comprend un ensemble de tores de courant $TC_i$ (i=1, 2, 3, ..., N), un ensemble de modules de détection de courant $DC_i$ (i=1, 2, 3, ..., N), un ensemble de capteurs de pression $P_i$ (i=1, 2, 3, ..., N), un ensemble de modules de surveillance de gaz $MG_i$ (i=1, 2, 3, ..., N) et un organe de supervision SP. Selon le mode de réalisation préférentiel de l'invention, chaque tore de courant $TC_i$ est monté sur le compartiment $CP_i$ sensiblement au niveau de l'extrémité du compartiment $CP_i$ voisine du compartiment $CP_{i+1}$ et chaque capteur de pression $P_i$ est monté sur le compartiment $CP_i$ sensiblement au niveau de l'extrémité du compartiment voisine du compartiment $CP_{i-1}$. Chaque module de détection $DC_i$ comprend, entre autres, un circuit électronique de traitement qui a pour fonction une mise en forme du signal délivré par le tore de courant TCi afin que ce signal puisse être traité par le module de détection $DC_i$. L'organe de supervision SP est, par exemple, un calculateur, un ordinateur ou un microprocesseur.

Chaque module de détection de courant $DC_i$ (i=1, 2, ..., N) reçoit en entrée le courant Ii qui parcourt le tore $TC_i$ et le courant $I_{i-1}$ qui parcourt le tore $TC_{i-1}$. Par ailleurs, chaque capteur de pression $P_i$ est relié au module de surveillance de gaz $MG_i$ et l'ensemble des modules de détection $DC_i$ et des modules de surveillance de gaz MGi sont reliés entre eux et à l'organe de surveillance SP, via une même ligne de communication bi-directionnelle cb.

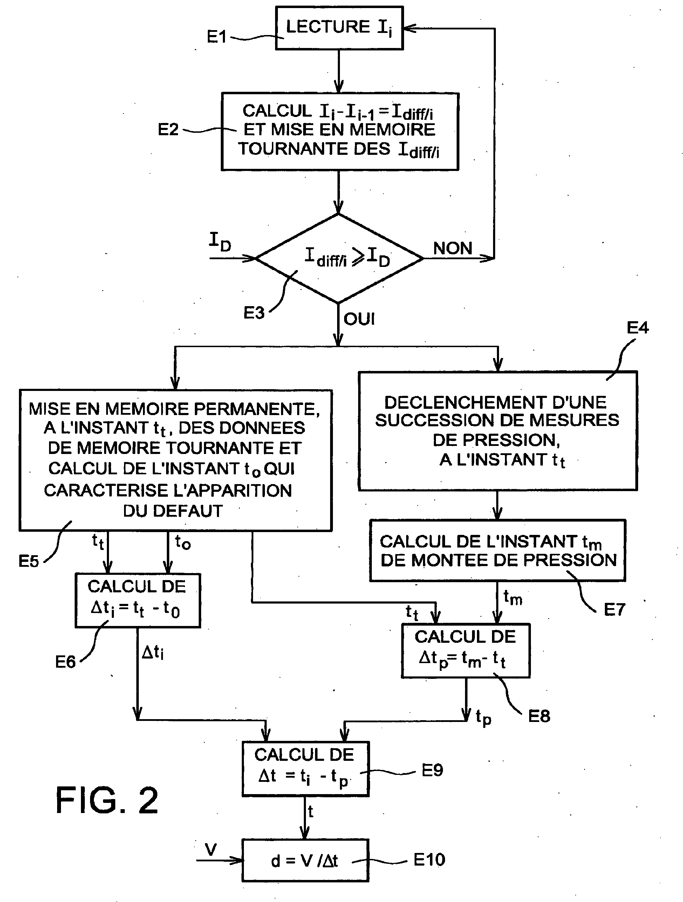

La figure 2 représente un schéma de principe du procédé de localisation d'arc interne .de ligne à isolation gazeuse de l'invention qui est mis en oeuvre par le dispositif de la figure 1. Le procédé comprend :

- une lecture, à une fréquence d'échantillonnage, des différents courants $I_i$ qui parcourent les différents tores de courant,
- un calcul, à la fréquence d'échantillonnage, des différences de courants $I_{diff/i}$ telles que :

$$I_{diff/i} = I_{i+1} - I_i,$$

avec une mise en mémoire tournante des différences de courant calculées,

- une comparaison des différences de courant $I_{diff/i}$ mises en mémoire tournante avec une valeur de seuil de courant et, à un instant $t_t$, dès lors qu'une différence de courant est supérieure ou égale à la valeur de seuil :
- une mise en mémoire permanente des différences de courant mises en mémoire tournante,
- un déclenchement d'une succession de mesures de pression par le capteur de pression $P_i$, avec une mise en mémoire des valeurs de pression mesurées,
- un calcul, à partir des variations temporelles des mesures de pression mises en mémoire, d'un instant $t_m$ de montée de pression, comme instant auquel commence à croître la pression mesurée par le capteur de pression $P_i$,
- un calcul d'une durée $\Delta t_P$ comme la différence des instants $t_m$ et $t_t$,
- un calcul d'un instant $t_0$ qui caractérise l'apparition d'un arc interne dans le compartiment $CP_i$ à partir des variations temporelles de différences de courant mises en mémoire permanente,

- un calcul d'une durée $\Delta t_i$ comme différence des instants $t_t$ et $t_0$,
- un calcul d'une durée $\Delta t$ comme la somme des durées précédemment calculées $\Delta t_i$ et $\Delta t_P$, et
- un calcul de la distance d qui sépare le capteur de pression $P_i$ de l'endroit où est apparu l'arc interne par l'équation :

$$d = V/\Delta t$$

où V est la vitesse de propagation du son dans le gaz.

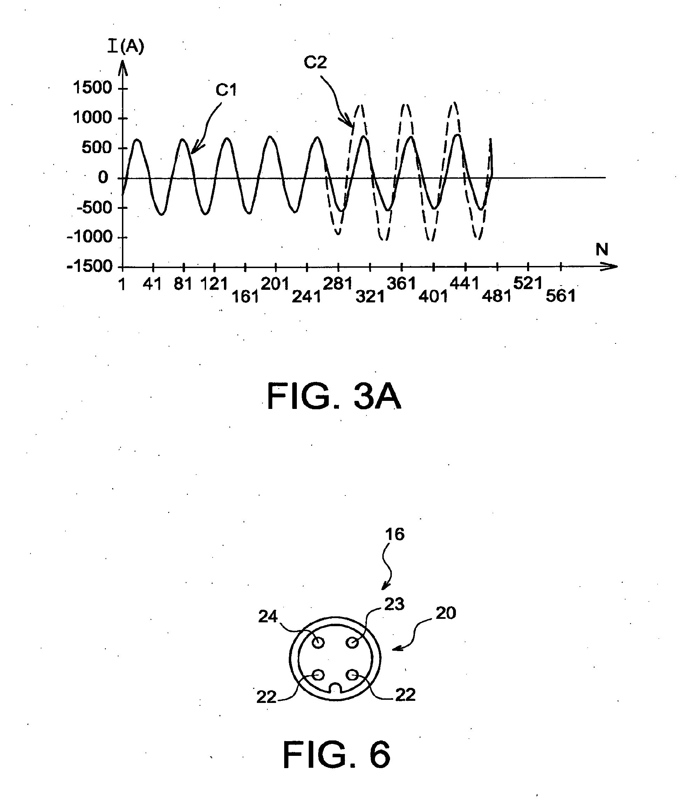

En l'absence de perturbation, un courant sinusoïdal parcourt chacun des tores de courant $TC_i$. Le courant sinusoïdal qui parcourt chaque tore a une amplitude constante qui est identique d'un tore à l'autre, par exemple 4000A. La courbe C1 de la figure 3A représente ainsi, par exemple, la variation en fonction du temps du courant $I_i$ pour tout i (la variable temps est représentée sur la figure 3A par la succession des nombres de point d'échantillonnage N). Lorsqu'un défaut survient, par exemple dans le compartiment $CP_i$ (cf. l'arc A représenté entre le conducteur K et l'enveloppe conductrice sur la figure 3A), le courant $I_i$ qui parcourt le tore $TC_i$ voit son amplitude croître (cf. courbe C2 sur la figure 3A) alors que le courant $I_{i-1}$ demeure, pour l'exemple, inchangé (cf. courbe C1).

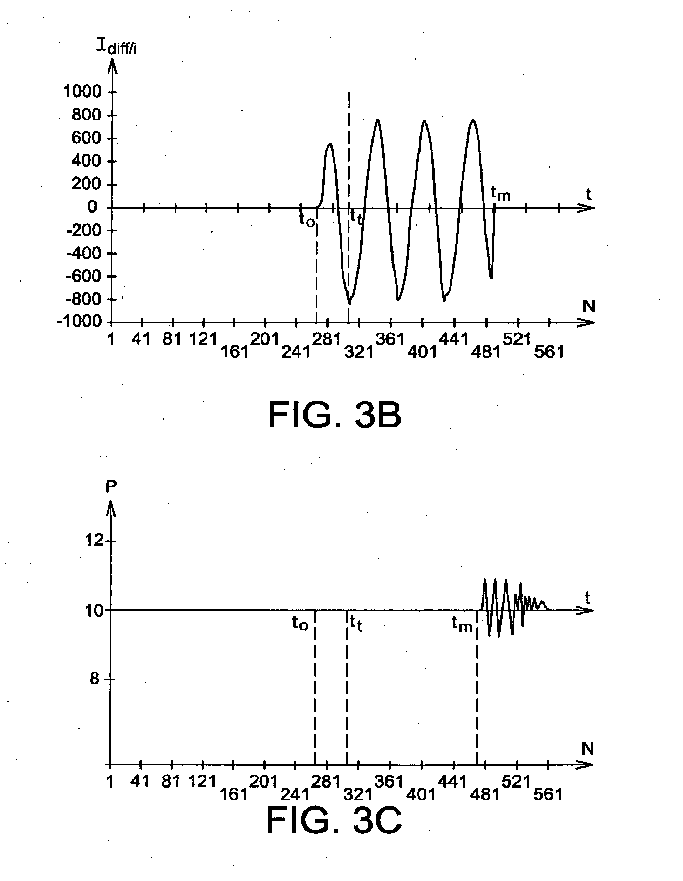

La figure 3B représente la courbe du courant $I_{diff/i}$ qui est la différence entre les courants Ii et $I_{i-1}$ de la figure 3A. Dès lors que l'amplitude de la différence du courant $I_{diff/i}$ dépasse la valeur de seuil $I_D$ (ici, par exemple, 800A), le module de détection de courant $DC_i$ commande le module de surveillance de gaz $MG_i$, lequel déclenche, en conséquence, à l'instant $t_t$, une succession de mesures de pression du gaz pendant une durée $\Delta\tau$, par exemple égale à 500ms (durée avantageusement compatible avec la localisation précise de l'endroit où s'amorce un arc de défaut dans un compartiment de 70m de long, sur la base d'une vitesse de déplacement de l'onde dans le gaz de 136m/s). Par ailleurs, les valeurs des différences de courant $I_{diff/i}$ mises en mémoire tournante sont mises en mémoire permanente dans le module $DC_i$. Un algorithme de calcul préalablement enregistré dans l'organe de supervision SP, par exemple un algorithme basé sur le calcul de la dérivée mathématique du courant différentiel, calcule alors, à partir des variations temporelles des différences de courant mises en mémoire permanente, l'instant $t_0$ qui caractérise l'apparition du défaut dans le compartiment $CP_i$. A l'issue du calcul de l'instant $t_0$, la durée $\Delta t_i$ qui sépare l'instant $t_t$ de l'instant $t_0$ est calculée par l'organe de supervision SP.

Parallèlement, dès lors qu'elles débutent, les mesures de pression sont mises en mémoire dans le module $MG_i$. A la fin de la durée $\Delta\tau$ de mesure des pressions, un algorithme de calcul enregistré dans l'organe de supervision SP, par exemple un algorithme basé sur le calcul de la dérivée mathématique de la pression, est mis en oeuvre pour calculer, à partir des variations temporelles des mesures de pression enregistrées, l'instant $t_m$ qui caractérise l'arrivée de l'onde de pression sur le détecteur de pression. Une fois l'instant $t_m$ calculé, la durée $\Delta t_P$ qui sépare l'instant $t_m$ de l'instant $t_t$ est calculée par l'organe de supervision SP. L'organe de supervision Sp calcule alors la durée $\Delta t$ ($\Delta t = \Delta t_i + \Delta t_P$) qui sépare l'instant d'arrivée du front d'onde de pression sur le capteur de pression de l'instant qui caractérise l'apparition du défaut dans le compartiment. La distance d qui sépare le capteur de l'endroit où apparaît le défaut est alors calculée par la formule qui suit :

$$d = V/t,$$

où V est la vitesse de propagation du son dans le gaz (par exemple 136m/s dans le cas du gaz SF6).

Selon une variante de l'invention, plusieurs capteurs de pression peuvent être utilisés pour mesurer la pression du gaz dans un même compartiment. C'est le cas où les compartiments ont une longueur importante et où les ondes de pression déclenchées par la survenue d'un arc électrique peuvent ne pas être détectées par un capteur unique trop éloigné de l'arc. Par exemple, deux capteurs de pression peuvent être montés sur un même compartiment, un premier capteur à proximité d'une première extrémité du compartiment et l'autre capteur à proximité de l'extrémité opposée du compartiment. Les deux capteurs de pression sont alors déclenchés simultanément et ce sont les mesures effectuées par au moins l'un des deux capteurs de pression qui participent à la localisation du défaut. Le tore de courant est ici placé, par exemple, au niveau du centre du compartiment.

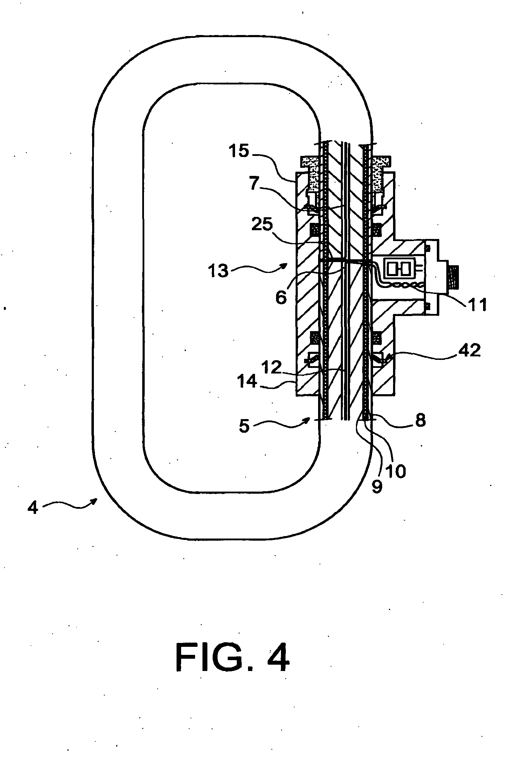

Les figures 4-6 représentent, à titre d'exemple non limitatif, des vues détaillées d'un tore de courant qui participe au dispositif de localisation d'arc interne de ligne à isolation gazeuse selon le mode de réalisation préférentiel de l'invention :

- la figure 4 est une vue générale du tore de courant,

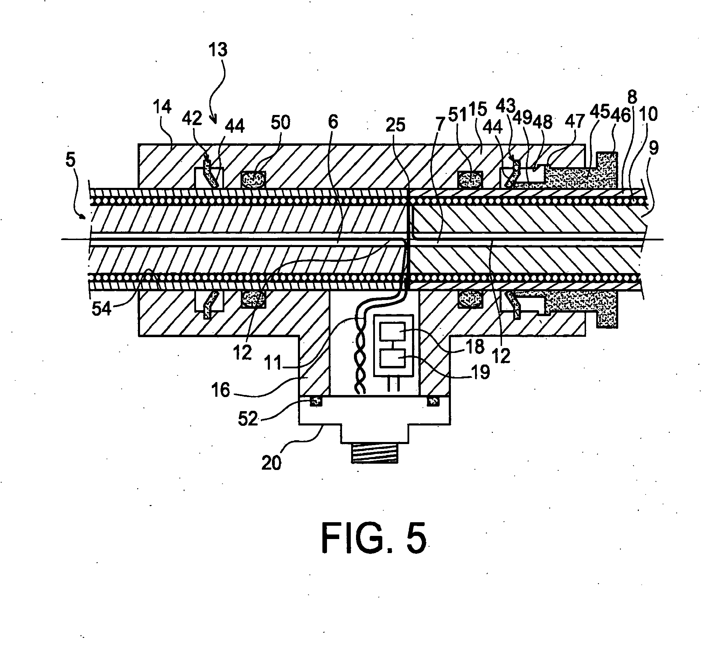

- la figure 5 est une vue détaillée du tore de courant, et

- la figure 6 est une vue en coupe de la connexion électrique qui équipe le tore de courant.

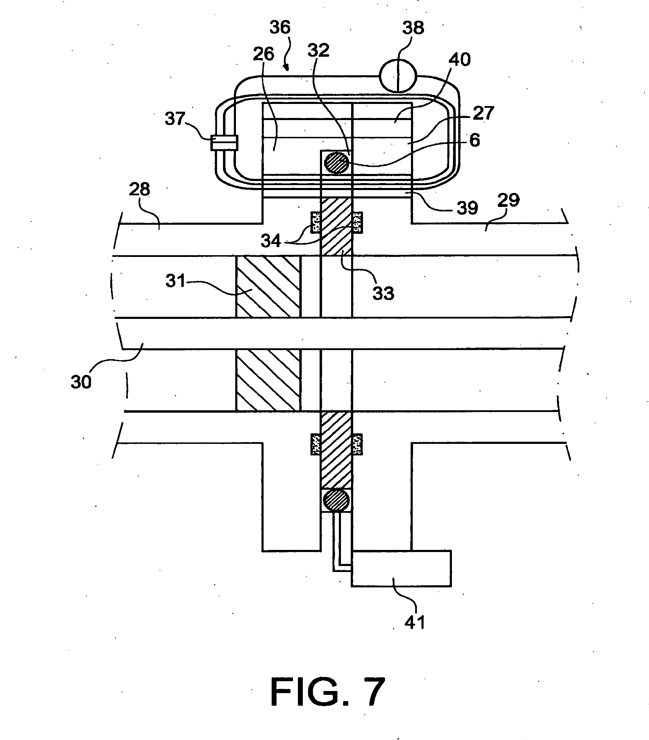

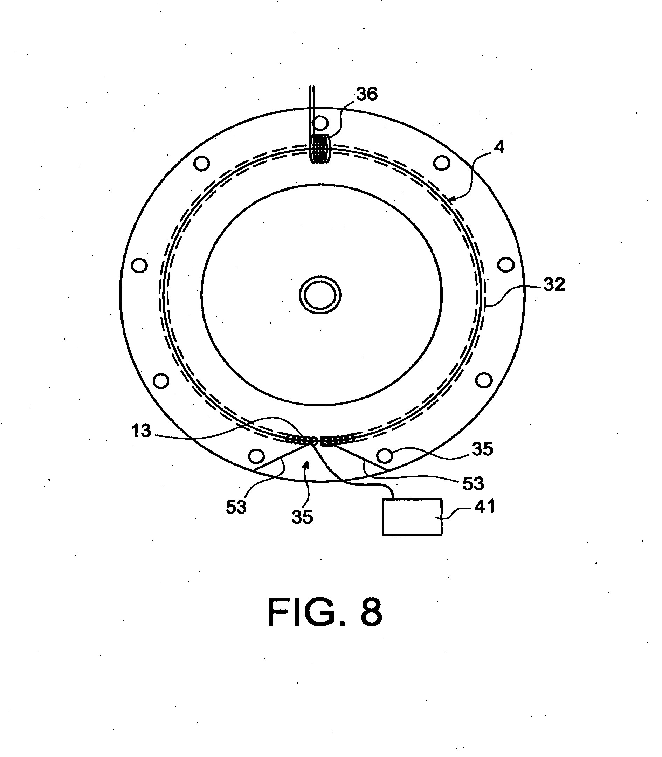

Les figures 7 et 8 illustrent deux vues, respectivement en coupe axiale et en coupe diamétrale, d'un appareillage équipé d'un tore de courant.

Le tore est formé par un câble 5 pouvant être refermé en boucle en aboutant ses extrémités l'une contre l'autre. Le câble 5 comprend une couche externe 8 de gaine, pouvant être en polyuréthane souple de 14mm de diamètre extérieur, et une couche interne 9 de gaine concentrique à la précédente et en polyuréthane ou en polyamide. Un bobinage 10 en fil conducteur, pouvant être isolé par une gaine plastique ou par un vernis est encastré entre les deux couches de gaine et s'étend sur toute la longueur du câble 5, d'une extrémité 6 à l'autre 7. Le bobinage 10 finit sur un fil d'entrée 11 quittant le câble 5 et un fil de sortie 12 s'étendant à l'intérieur de la gaine interne 9 depuis l'extrémité 7 jusqu'à l'autre extrémité 6 avant de quitter le câble 5 lui aussi. La couche interne 9 de gaine est avantageusement assez épaisse pour ne pas transmettre de déplacements importants du fils de sortie 12 et le maintenir au centre du câble 5. Le capteur 4 comprend encore un raccord 13 sous la forme d'un manchon, comprenant une première branche 14 pour loger fixement une extrémité 6, une deuxième branche 15 pour recevoir l'autre extrémité 7 avec la possibilité de la déplacer et de l'extraire complètement et une troisième branche 16, perpendiculaire aux précédentes, et qui reçoit les fils d'entrée 11 et de sortie 12.

La troisième branche 16 comprend encore une sonde de température 18 et un dispositif de paramétrage 19 à mémoire, contenant les paramètres de calibration du capteur 4 et son numéro de série, qui permettent de corréler le courant induit dans le bobinage 10 par un courant circulant par le conducteur autour duquel le capteur est bouclé et qui ont été obtenus par des étalonnages préliminaires. La troisième branche 16 finit sur une broche de connexion électrique 20 comprenant des connexions 22 au fil d'entrée 11, 23 au fil de sortie 12 et 24 aux dispositifs 18 et 19. Un dispositif de commande (41 sur d'autres figures) connecté à la branche 20 permet de recueillir le courant passant par le bobinage 10 et d'exploiter les dispositifs 18 et 19. Il peut aussi injecter de petites quantités de courant dans le câble 5 pour vérifier périodiquement sa continuité. Du fait de l'amplitude faible du signal de sortie du capteur, soit quelques dizaines de millivolts par kiloampère, le dispositif de commande est monté de préférence à proximité, soit au plus quelques mètres. D'autre part, le câble de liaison comporte un écran externe destiné è protéger le signal contre les perturbations électromagnétiques; et les deux paires de fils qu'il contient, menant aux connexions 21 à 24, sont torsadées individuellement. Le dispositif de commande amplifie et traite le signal de sortie du capteur en fonction du besoin. Il autorise également une correction de ce signal en fonction des paramètres de la sonde de température 18 et des paramètres d'étalonnage du dispositif 19.

Conformément à l'invention, le manchon 13 est traversé complètement à l'endroit de la première branche 14 et de la dernière branche 15 par un perçage 54, les extrémités 6 et 7 du câble 5 sont ouvertes c'est-à-dire dépourvues d'embout, et le bobinage 10 affleure sur des surfaces extrêmes 25, qui sont droites (planes, ou sans relief) et peuvent donc être aboutées l'une sur l'autre quelque part dans le perçage 54 en poussant suffisamment l'extrémité 7 dans la dernière branche 15. Le raccord 13, pourvu d'un évidement 42 le traversant de part en part dans la première branche 14 et la dernière branche 15, et qui est parfaitement cylindrique, permet le contact des extrémités 6 et 7. Le bobinage 10 s'étend alors sur une circonférence presque continue qui assure une mesure précise. Le réglage impliquant seulement une mise en butée du câble 5 par ce contact, il est facile à établir de façon sûre. Aucune vérification ou aucune recalibration n'est nécessaire. Il est assez souple pour pouvoir être plié dans le perçage 35 et introduit dans la gorge 32 de l'extérieur ; et le perçage 35 est assez large à l'intérieur pour que l'introduction du manchon 13 et la fermeture de la boucle du câble 5 soient aussi faciles.

Selon d'autres dispositions importantes, le manchon 13 est muni de deux bagues de blocage 42 et 43 du câble 5 en translation, dans la première branche 14 et la dernière branche 15 où elles sont retenues dans des gorges. Les bagues de blocage 42 et 43 comprennent chacune une portion conique 44 dégagée et frottant sur la gaine externe 8 des extrémités 6 et 7 et dirigées l'une vers l'autre, de sorte que l'introduction des extrémités 6 et 7 dans le manchon 13 est facile grâce à une déformation élastique de la portion conique 44 mais leur extraction est empêchée par un arc-boutement de celle-ci. La fermeture du câble 5 est ainsi maintenue en toutes circonstances, sauf quand un poussoir 45, établi dans la deuxième branche 15, est mis en mouvement. Il comprend une portion extérieure 46, dépassant hors du manchon 13 mobile et servant à la préhension, un ergot 47 mobile dans une rainure 48 creusée dans le manchon 13 avec une extension finie, et une pointe 49 dirigée vers la portion conique 44 de la bague de blocage 43. En poussant sur la portion extérieure 46, on enfonce le poussoir 45 et la pointe 49 repousse la portion conique en la déformant élastiquement et la dégageant de l'extrémité 7, qui peut alors être retirée pour ouvrir la boucle du câble 5. Dans la portion normale, représentée à la figure 3, le poussoir 45 est toutefois séparé de la bague de blocage 43. La longueur et la position de la rainure 47 sont choisies pour autoriser ces deux états. La première branche 14 du manchon 13 peut être dépourvue de poussoir, l'extrémité 6 y étant logée de façon permanente. Le manchon 13 comprend encore deux joints d'étanchéité circulaires 50 et 51 dans deux autres rainures des branches 14 et 15 pour enserrer les extrémités 6 et 7 du câble 5 et établir une étanchéité de sa jonction ; la troisième branche 16 est elle-même isolée par un troisième joint 52 que l'embout 20 comprime sur elle.

Les figures 5 et 6 illustrent l'utilisation du capteur 4 avec un câble électrique blindé et à isolation gazeuse. Le capteur 4 est ici disposé entre les brides de jonction 26 et 27 de deux tronçons 28 et 29 d'enveloppe du Câble 30 électrique à surveiller, qui s'étend au centre des tronçons 28 et 29 en étant soutenu par des isolateurs 31. Le capteur 4 s'étend dans une gorge 32 circulaire et continue d'une des brides 26, autour d'un flasque isolant 33 complété par des joints d'étanchéité aux gaz 34. Le dispositif de commande 41 du capteur 4 est représenté fixé à l'autre bride 25. Avantageusement, la gorge 32 est circonscrite par des perçages des boulons 40 afin que ceux-ci n'altèrent pas la mesure.

L'élément essentiel de cette réalisation est que la gorge 32 communique à l'extérieur seulement par une ouverture 35 en éventail, par laquelle le capteur 4 peut être introduit en commençant par l'extrémité 6. Le câble 5 progresse ainsi dans la gorge 32 en s'enroulant peu à peu, et forme naturellement une boucle quand le raccord 13 a été enfoncé dans la gorge 32. Les bords 53 de l'ouverture 35 sont en effet assez proches de la tangente avec la gorge 32, et le câble 5 est assez souple pour pouvoir être plié dans le perçage 35 et introduit dans la gorge 32 de l'extérieur ; et l'ouverture 35 est assez large à l'intérieur pour que l'introduction du manchon 13 et la fermeture de la boucle du câble 5 soient aussi faciles. Cette disposition permet de ne pas démonter l'enveloppe du câble 30 quand une manipulation sur le capteur 4 est nécessaire.

Une autre disposition concerne un bobinage de test 36 autonome qui peut être utilisé pour le test du capteur 4 en injectant un courant qui s'ajoute au courant primaire. Ce bobinage de test 36, peu intrusif, ne nécessite pas de démontage. Il peut être un câble ouvert pouvant être bouclé à une jonction 37, composé d'un certain nombre de spires et alimenté par un générateur de courant 38. Il passe par un perçage 39 établi à travers les brides 26 et 27 entre le flasque 33 et le capteur 4. L'autre côté passe à l'extérieur des brides 26 et 27 pour entourer une section du capteur 4.

**Revendications**

1. Procédé de localisation d'un arc interne qui survient dans une ligne à isolation gazeuse constituée d'une succession de compartiments $CP_i$ (i=1, 2, ..., N) remplis de gaz, **caractérisé en ce que**, chaque compartiment $CP_i$ étant entouré par un tore de courant $TC_i$ (i=1, 2, ..., N) parcouru par un courant $I_i$ sensiblement identique d'un compartiment à l'autre et étant muni d'au moins un capteur de pression $P_i$ apte à mesurer la pression du gaz à l'intérieur du compartiment, il comprend :

   - une lecture (E1), à une fréquence d'échantillonnage, des différents courants $I_i$ qui parcourent les différents tores de courant,
   - un calcul (E2), à la fréquence d'échantillonnage, des différences de courants $I_{diff/i}$ telles que :

$$I_{diff/i} = I_{i+1} - I_i,$$

   avec une mise en mémoire des différences de courant calculées,
   - une comparaison (E3) des différences de courant $I_{diff/i}$ mises en mémoire avec une valeur de seuil de courant et, dès lors qu'une différence de courant est supérieure ou égale à la valeur de seuil à un instant $t_t$ :
   - un déclenchement (E4) d'une succession de mesures de pression par le capteur de pression $P_i$, avec une mise en mémoire des valeurs de pression mesurées,
   - une étape de calcul (E7), à partir des variations temporelles des mesures de pression mises en mémoire, d'un instant $t_m$ de montée de pression, comme instant auquel commence à croître la pression mesurée par le capteur de pression $P_i$,
   - une étape de calcul (E8) d'une durée $\Delta t_P$ comme la différence des instants $t_m$ et $t_t$,
   - un calcul (E5) d'un instant $t_0$ qui caractérise l'apparition d'un arc interne dans le compartiment $CP_i$ à partir des variations temporelles de différences de courant mises en mémoire,
   - un calcul (E6) d'une durée $\Delta t_i$ comme différence des instants $t_t$ et $t_0$,
   - un calcul (E9) d'une durée $\Delta t$ comme la somme des durées précédemment calculées $\Delta t_i$ et $\Delta t_P$, et
   - un calcul (E10) de la distance d qui sépare le capteur de pression $P_i$ de l'endroit où est apparu le défaut par l'équation :

$$d = V/\Delta t$$

   où V est la vitesse de propagation du son dans le gaz.

**2.** Procédé selon la revendication 1, dans lequel le tore de courant $TC_i$ entoure une première extrémité du compartiment $CP_i$ et le capteur de pression $P_i$ est monté sur l'extrémité du compartiment opposée à la première extrémité.

**3.** Procédé selon la revendication 1, dans lequel un premier capteur de pression $P_i$ est monté sur le compartiment, à une première extrémité du compartiment et un deuxième capteur de pression $P_i$ est monté sur le compartiment à l'extrémité du compartiment opposée à la première extrémité.

**4.** Dispositif de localisation d'un arc interne qui survient dans une ligne à isolation gazeuse constituée d'une succession de compartiments $CP_i$ (i=1, 2, ..., N) remplis de gaz, **caractérisé en ce qu'**il comprend :

- N tores de courant $TC_i$ (i=1, 2, ..., N), chaque tore de courant entourant un compartiment et étant parcouru par un courant $I_i$ sensiblement identique d'un compartiment à l'autre,.
- N modules de détection $DC_i$ (i=1, 2, ..., N), chaque module de détection étant apte à lire le courant $I_i$ qui parcourt le tore de courant $TC_i$ et le courant $I_{i-1}$ qui parcourt le tore de courant $TC_{i-1}$ et comprenant des moyens aptes à calculer les différences des courants $I_i$ et $I_{i-1}$, à mémoriser les différences de courant calculées et à délivrer, à un instant $t_t$, un signal de commande dès lors que la différence des courants $I_i$ et $I_{i-1}$ est supérieure ou égale à un seuil,
- au moins un capteur de pression $P_i$ monté sur chaque compartiment $CP_i$ et apte à mesurer la pression du gaz à l'intérieur du compartiment,
- N modules de surveillance de gaz $MG_i$ (i=1, 2, ..., N), chaque module de surveillance de gaz comprenant des moyens aptes à déclencher, sous l'action du signal de commande, via le capteur de pression $P_i$, des mesures successives de pression du gaz contenu dans le compartiment $CP_i$ et à mémoriser les mesures de pression successives effectuées, et
- des moyens (SP) aptes à calculer :

→ un instant $t_m$ de montée de pression, comme instant auquel commence à croître la pression mesurée par le capteur de pression $P_i$, à partir des variations temporelles des mesures de pression mises en mémoire,
→ une durée $\Delta t_P$ comme la différence des instants $t_m$ et $t_t$,
→ un instant $t_0$ qui caractérise l'apparition d'un arc interne dans le compartiment $CP_i$ à partir des variations temporelles de différences de courant mises en mémoire,
→ une durée $\Delta t_i$ comme différence des instants $t_t$ et $t_0$,
→ une durée $\Delta t$ comme la somme des durées précédemment calculées $\Delta t_i$ et $\Delta t_P$, et
→ une distance d qui sépare le capteur de pression $P_i$ de l'endroit où est apparu le défaut par l'équation :

$$d=V/\Delta t$$

où V est la vitesse de propagation du son dans le gaz.

**5.** Dispositif selon la revendication 4, dans lequel le tore de courant $TC_i$ entoure une première extrémité du compartiment $CP_i$ et un capteur de pression $P_i$ est monté sur l'extrémité du compartiment opposée à la première extrémité.

**6.** Dispositif selon la revendication 4, dans lequel un premier capteur de pression $P_i$ est monté sur le compartiment à une première extrémité du compartiment, un deuxième capteur de pression $P_i$ est monté sur le compartiment à l'extrémité du compartiment opposée à la première extrémité et le tore de courant entoure le compartiment sensiblement au centre du compartiment.


**Patentansprüche**

**1.** Verfahren zur Ortung eines inneren Lichtbogens, der in einer gasisolierten Leitung auftritt, die aus einer Folge von gasgefüllten Fächern $CP_i$ (i = 1, 2, ..., N) besteht, **dadurch gekennzeichnet, dass** jedes Fach $CP_i$ von einer Stromringspule $TC_i$ (i = 1, 2, ..., N) umgeben wird, die von einem Strom $I_i$ durchflossen wird, der von einem Fach zum anderen im Wesentlichen identisch, und mit zumindest einem Drucksensor $P_i$ versehen ist, der dazu geeignet ist, den Gasdruck im Inneren des Fachs zu messen, wobei es umfasst:

- Auslesen (E1) der verschiedenen Ströme $I_i$, die durch die verschiedenen Stromringspulen fließen, mit einer Abtastfrequenz,
- Berechnen (E2) der Stromdifferenzen $I_{diff/i}$ mit der Abtastfrequenz, so dass:

$$I_{diff/i} = I_{i+1} - I_i$$

mit Abspeichern der errechneten Stromdifferenzen,
- Vergleichen (E3) der abgespeicherten Stromdifferenzen $I_{diff/i}$ mit einem Stromschwellenwert und im Falle einer Stromdifferenz, die höher oder gleich dem Schwellenwert zu einem Zeitpunkt $t_t$ ist:
- Einleiten (E4) einer Folge von Druckmessungen über den Drucksensor $P_i$ mit Abspeichern der gemessenen Druckwerte,
- einen Rechenschritt (E7), um ausgehend von zeitlichen Schwankungen der abgespeicherten Druckmessungen einen Zeitpunkt $t_m$ des Druckanstiegs als Zeitpunkt zu berechnen, bei dem der über den Drucksensor $P_i$ gemessene Druck zu steigen beginnt,
- einen Rechenschritt (E8) zum Berechnen einer Zeitdauer $\Delta t_P$ als Differenz der Zeitpunkte $t_m$ und $t_t$,
- Berechnen (E5) eines Zeitpunkts $t_0$, der das Auftreten eines inneren Lichtbogens in dem Fach $CP_i$ kennzeichnet, und zwar ausgehend von den zeitlichen Schwankungen der abgespeicherten Stromdifferenzen,
- Berechnen (E6) einer Zeitdauer $\Delta t_i$ als Differenz der Zeitpunkte $t_t$ und $t_0$,
- Berechnen (E9) einer Zeitdauer $\Delta t$ als Summe der zuvor berechneten Zeitdauern $\Delta t_i$ und $\Delta t_p$, und
- Berechnen (E10) der Entfernung d, welche den Drucksensor $P_i$ von der Stelle trennt, wo der Fehler aufgetreten ist, durch die Gleichung:

$$d = V / \Delta t$$

wobei V die Schallgeschwindigkeit in dem Gas ist.

2. Verfahren nach Anspruch 1, wobei die Stromringspule $TC_i$ ein erstes Ende des Fachs $CP_i$ umgibt und der Drucksensor $P_i$ an dem dem ersten Ende entgegengesetzten Ende des Fachs montiert ist.

3. Verfahren nach Anspruch 1, wobei ein erster Drucksensor $P_i$ an einem ersten Ende des Fachs an dem Fach montiert ist und ein zweiter Drucksensor Pi an dem dem ersten Ende entgegengesetzten Ende des Fachs an dem Fach montiert ist.

4. Vorrichtung zur Ortung eines inneren Lichtbogens, der in einer gasisolierten Leitung auftritt, die aus einer Folge von gasgefüllten Fächern $CP_i$ (i = 1, 2, ..., N) besteht, **dadurch gekennzeichnet, dass** sie enthält:

- N Stromringspulen $TC_i$ (i = 1, 2, ..., N), wobei jede Stromringspule ein Fach umgibt und von einem Strom $I_i$ durchflossen wird, der von einem Fach zum anderen im Wesentlichen identisch,
- N Erfassungsmodule $DC_i$ (i = 1, 2, ..., N), wobei jedes Erfassungsmodul dazu geeignet ist, den Strom $I_i$, der durch die Stromringspule $TC_i$ fließt, und den Strom $I_{i-1}$ auszulesen, der durch die Stromringspule $TC_{i-1}$ fließt, sowie Mittel, die dazu geeignet sind, die Stromdifferenzen $I_i$ und $I_{i-1}$ zu berechnen, die berechneten Stromdifferenzen abzuspeichern und zu einem Zeitpunkt $t_t$ ein Steuersignal für den Falle auszugeben, dass die Stromdifferenz der Ströme $I_i$ und $I_{i-1}$ höher oder gleich einem Schwellwert ist,
- zumindest einen Drucksensor $P_i$, der an jedem Fach $CP_i$ montiert ist und dazu geeignet ist, den Gasdruck im Inneren des Fachs zu messen,
- N Gasüberwachungsmodule $MG_i$ (i = 1, 2, ..., N), wobei jedes Gasüberwachungsmodul Mittel aufweist, die dazu geeignet sind, unter der Wirkung des Steuersignals über den Drucksensor $P_i$ aufeinanderfolgende Druckmessungen des in dem Fach $CP_i$ enthaltenen Gases einzuleiten und die durchgeführten aufeinanderfolgenden Druckmessungen abzuspeichern, und
- Mittel (SP), die dazu geeignet sind, zu berechnen:

→ einen Zeitpunkt $t_m$ des Druckanstiegs als Zeitpunkt, an dem der über den Drucksensor $P_i$ gemessene Druck zu steigen beginnt, und zwar ausgehend von zeitlichen Schwankungen der abgespeicherten Druckmessungen,
→ eine Zeitdauer $\Delta t_P$ als Differenz der Zeitpunkte $t_m$ und $t_t$,

→ einen Zeitpunkt $t_0$, der das Auftreten eines inneren Lichtbogens in dem Fach $CP_i$ kennzeichnet, und zwar ausgehend von den zeitlichen Schwankungen der abgespeicherten Stromdifferenzen,
→ eine Zeitdauer $\Delta t_i$ als Differenz der Zeitpunkte $t_t$ und $t_0$,
→ eine Zeitdauer $\Delta t$ als Summe der zuvor berechneten Zeitdauern $\Delta t_i$ und $\Delta t_p$, und
→ einer Entfernung d, welche den Drucksensor $P_i$ von der Stelle trennt, wo der Fehler aufgetreten ist, durch die Gleichung:

$$d = V / \Delta t$$

wobei V die Schallgeschwindigkeit in dem Gas ist.

5. Vorrichtung nach Anspruch 4, wobei die Stromringspule $TC_i$ ein erstes Ende des Fachs $CP_i$ umgibt und ein Drucksensor $P_i$ an dem dem ersten Ende entgegengesetzten Ende des Fachs montiert ist.

6. Vorrichtung nach Anspruch 4, wobei ein erster Drucksensor $P_i$ an einem ersten Ende des Fachs am Fach montiert ist, ein zweiter Drucksensor $P_i$ an an dem ersten Ende entgegengesetzten Endes des Fachs am Fach montiert ist und die Stromringspule das Fach im Wesentlichen im Zentrum des Fachs umgibt.

**Claims**

1. A method of locating an internal arc in a gas-insulated line consisting of a succession of compartments $CP_i$ (i = 1, 2, ..., N) filled with gas, the method being **characterized in that**, for each compartment $CP_i$ being surrounded by a current toroid $TC_i$ (i = 1, 2, ..., N) through which there flows a current $I_i$ that is substantially identical from one compartment to another and being provided with at least one pressure sensor $P_i$ able to measure the pressure of the gas inside the compartment, the method comprises the following steps:

reading (E1), at a sampling frequency, the currents Ii that flow through the current toroids;
calculating (E2), at the sampling frequency, current differences $I_{diff/i}$ such that $I_{diff/i} = I_{i+1} - I_i$, and storing the calculated current differences;
comparing (E3) the stored current differences $I_{diff/i}$ with a current threshold value and, as soon as a current difference is greater than or equal to the threshold value at a time $t_t$:

triggering (E4) a succession of pressure measurements by the pressure sensor $P_i$, and storing the measured pressure values;
calculating (E7) from the time variations of the stored pressure measurements a pressure rise time $t_m$ at which the pressure measured by the pressure sensor $P_i$ begins to increase;
calculating (E8) a period $\Delta t_P$ that is the difference between the times $t_m$ and $t_t$;
calculating (E5) a time to that characterizes the occurrence of internal arcing in the compartment $CP_i$ from the time variations of the stored current differences;
calculating (E6) a period $\Delta t_i$ that is the difference between the times $t_t$ and to;
calculating (E9) a period $\Delta t$ that is the sum of the previously-calculated periods $\Delta t_i$ and $\Delta t_P$; and
calculating (E10) the distance <u>d</u> that separates the pressure sensor Pi from the place at which the fault occurred using the equation d = V/$\Delta t$ in which V is the speed of propagation of sound in the gas.

2. A method according to claim 1, wherein the current toroid $TC_i$ surrounds a first end of the compartment $CP_i$ and the pressure sensor $P_i$ is mounted on the end of the compartment opposite the first end.

3. A method according to claim 1, wherein a first pressure sensor $P_i$ is mounted on the compartment at a first end of the compartment and a second pressure sensor $P_i$ is mounted on the compartment at the end of the compartment opposite the first end.

4. A device for locating an internal arc in a gas-insulated line consisting of a succession of compartments $CP_i$ (i = 1, 2, ..., N) filled with gas, the device being **characterized in that** it comprises:

N current toroids $TC_i$ (i = 1, 2, ..., N), each current toroid surrounding a compartment and having flowing through

it a current $I_i$ that is substantially identical from one compartment to another;

N detection modules $DC_i$ (i = 1, 2, ..., N), each detection module able to read the current $I_i$ flowing through the current toroid $TC_i$ and the current $I_{i-1}$ flowing through the current toroid $TC_{i-1}$ and including means for calculating the differences between the currents $I_i$ and $I_{i-1}$, for storing the calculated current differences, and for delivering a command signal at a time $t_t$, as soon as the difference between the currents $I_i$ and $I_{i-1}$ is greater than or equal to a threshold;

at least one pressure sensor $P_i$ mounted on each compartment $CP_i$ and able to measure the pressure of the gas inside the compartment;

N gas monitoring modules $MG_i$ (i = 1, 2, ..., N) each gas monitoring module including means able to respond to the command signal by triggering successive measurements by the pressure sensor $P_i$ of the pressure of the gas contained in the compartment $CP_i$ and storing the successive pressure measurements effected; and

means (SP) able to calculate:

> from the time variations of the stored pressure measurements, a pressure rise time $t_m$ that is the time at which the pressure measured by the pressure sensor $P_i$ begins to increase;
>
> a period $\Delta t_P$ that is the difference between the times $t_m$ and $t_t$;
>
> from the time variations of the stored current differences, a time to that characterizes the occurrence of internal arcing in the compartment $CP_i$;
>
> a period $\Delta t_i$ that is the difference between the times $t_t$ and $t_0$;
>
> a period $\Delta t$ that is the sum of the previously-calculated periods $\Delta t_i$ and $\Delta t_P$; and
>
> a distance $\underline{d}$ that separates the pressure sensor $P_i$ from the place at which the fault has occurred from the equation d = V/$\Delta$t in which V is the speed of propagation of sound in the gas.

5. A device according to claim 4, wherein the current toroid $TC_i$ surrounds a first end of the compartment $CP_i$ and a pressure sensor $P_i$ is mounted on the end of the compartment opposite the first end.

6. A device according to claim 4, wherein a first pressure sensor $P_i$ is mounted on the compartment at a first end of the compartment, a second pressure sensor $P_i$ is mounted on the compartment at the end of the compartment opposite the first end, and the current toroid surrounds the compartment substantially at the center of the compartment.

FIG. 1

**FIG. 2**

**FIG. 3A**

**FIG. 6**

FIG. 3B

FIG. 3C

FIG. 4

EP 2 585 838 B1

FIG. 5

FIG. 7

FIG. 8

**EP 2 585 838 B1**

**Documents brevets cités dans la description**

- FR 2719125 A1